# EUROPÄISCHE PATENTSCHRIFT

(11) **EP 2 435 755 B1**
(45) Veröffentlichungstag und Bekanntmachung des Hinweises auf die Patenterteilung: **30.03.2016**
(21) Anmeldenummer: 10721762.2
(22) Anmeldetag: 11.05.2010
(51) Int. Cl.: F21S 4/00

(54) **LEUCHTMODUL UND LEUCHTVORRICHTUNG**
LIGHTING MODULE AND LIGHTING DEVICE
MODULE D'ECLAIRAGE ET DISPOSITIF D'ECLAIRAGE

(30) Priorität: 28.05.2009 DE 102009023052
(43) Veröffentlichungstag der Anmeldung: 04.04.2012
(73) Patentinhaber: OSRAM GmbH, 80807 München (DE)
(72) Erfinder: BERTRAM, Ralph, 93152 Nittendorf (DE); FROST, Tobias, 93133 Burglengenfeld (DE); HERBOLD, Christian, 76135 Karlsruhe (DE); STRAUSS, Steffen, 93047 Regensburg (DE)
(86) Internationale Anmeldenummer: PCT/EP2010/056499
(87) Internationale Veröffentlichungsnummer: WO 2010/136333

(56) Entgegenhaltungen:
- EP-A1- 1 813 857
- EP-A2- 1 657 488
- WO-A2-2005/090852
- DE-U1- 29 603 557
- US-B1- 6 582 103

## Beschreibung

Die Erfindung betrifft ein Leuchtmodul mit mindestens einem flexiblen bandförmigen Träger für mehrere Wärmequellen sowie eine Leuchtvorrichtung mit mindestens einem Leuchtmodul.

Wärme erzeugende elektronische Bauteile, z.B. Leuchtdioden, müssen thermisch an wärmeabführende Komponenten (Kühlkörper, Gehäuse usw.) angebunden werden. Bei gekrümmten Gehäuse- oder Kühlkörperformen kann ein Standard-Schaltungsträger wie eine FR4- oder eine Metallkern-Platine nicht direkt angebunden werden. Dann kann eine seitliche thermische Anbindung der Metallkern-Platine verwendet werden, was aber eine schlechte Wärmeableitung bedingt, oder es können spezielle Strangpressprofile oder eine Kühlkörpergeometrie mit ebenen Flächen oder ebenen Ausfräsungen verwendet werden, was einen hohen Herstellungs- und Montageaufwand bedeutet, z. B. eine Montage mit Schrauben oder Klemmverbindungen.

Es sind ferner mit Leuchtdioden ausgestattete, in ihrer Längsrichtung biegsame Bänder (LED-Flex-Bänder) bekannt. So ist beispielsweise die LINEARlight Flex-Reihe der Fa. Osram bekannt, bei der ein LED-Band auf einer Rolle aufgewickelt erhältlich ist (z. B. der Reihe LM1X), wobei das Gesamtmodul je nach Ausführung 120 bis 600 LEDs umfasst. Das Grundmaß der kleinsten Einheit mit 10 LEDs (L x B) beträgt 140 mm x 10 mm. Ein minimaler Biegeradius des LED-Bands beträgt 2 cm. Das LED-Band weist eine selbstklebende Rückseite auf. Jedoch ist eine flächige Montage des LED-Flex-Bands auf einer bezüglich seiner Breite bzw. Quererstreckung gekrümmten Unterlage nicht vorgesehen.

Die EP 1 657 488 A2, die EP 1 813 857 A1 und die DE296 03 557 U1 zeigen jeweils ein Leuchtmodul, aufweisend mindestens einen flexiblen, insbesondere bandförmigen, Träger für mehrere Wärmequellen, einschließlich Lichtquellen, wobei der Träger dazu vorgesehen ist, über zumindest einen Teil seiner Breite gebogen zu werden. Die US 6 582 103 B1 zeigt eine Beleuchtungsvorrichtung, bei der in einem rohrförmigen Gehäuse eine Platine mit Leuchtdioden und einer flexiblen Reflektorfolie eingelegt ist.

Es ist die Aufgabe der vorliegenden Erfindung, eine Möglichkeit zur einfacheren Befestigung und verbesserten Wärmeableitung eines Leuchtmoduls auch auf einer bezüglich seiner Breitenerstreckung gekrümmten Unterlage bereitzustellen.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst mittels eines Leuchtmoduls, aufweisend mindestens einen flexiblen Träger für mehrere Lichtquellen, wobei der Träger dazu vorgesehen ist, über zumindest einen Teil seiner Breite gebogen bzw. verformbar zu werden. Das Leuchtmodul kann also dazu vorgesehen sein, zumindest abschnittsweise quer zu seiner Längserstreckung gebogen zu werden.

Der Träger kann in Form eines Schaltungsträgers bzw. einer Leiterplatte vorliegen.

Zusätzlich zu den Lichtquellen können auch noch weitere elektronische Bauteile, insbesondere andere Wärmequellen, auf dem Träger anordnet sein, vorzugsweise in einer Reihe mit den Lichtquellen. Eine mögliche weitere Ausgestaltung einer Wärmequelle kann ein elektronisches Bauelement wie ein Treiberbaustein oder ein Widerstand sein.

Der Träger kann gemäß einer Weiterbildung ein bandförmiger Träger sein. Dabei kann der Träger ein schmaler Träger sein, d. h., dass seine Längserstreckung, welche insbesondere durch eine Ausrichtung der Lichtquellen bestimmt sein kann, größer ist als seine Quererstreckung bzw. Breite. Alternativ kann der Träger ein breiter Träger sein, d. h., dass seine Längserstreckung, kürzer ist als seine Quererstreckung bzw. Breite.

Die Lichtquellen können Halbleiterlichtquellen und / oder andere Arten von Lichtquellen umfassen. Mindestens eine Halbleiterlichtquelle kann mindestens einen Diodenlaser und / oder mindestens eine Leuchtdiode aufweisen. Die Leuchtdiode kann einfarbig oder mehrfarbig, z. B. weiß, abstrahlen. Bei Vorliegen mehrerer Leuchtdioden können diese z. B. gleichfarbig (einfarbig oder mehrfarbig) und / oder verschiedenfarbig leuchten. So mag eine LED-Gruppe mehrere LED-Chips ('LED-Cluster') aufweisen, welche zusammen ein weißes Mischlicht ergeben können, z. B. in 'kaltweiß' oder 'warmweiß'. Zur Erzeugung eines weißen Mischlichts umfasst das LED-Cluster bevorzugt LED-Chips, die in den Grundfarben rot (R), grün (G) und blau (B) leuchten. Hierbei können eine oder mehrere Farben, insbesondere grün und rot auch durch Phosphorkonversion einer typischerweise blauen LED erzeugt sein. Dabei können einzelne oder mehrere Farben auch von mehreren LEDs gleichzeitig erzeugt werden; so sind Kombinationen RGB, RRGB, RGGB, RGBB, RGGBB usw. möglich. Jedoch ist die Farbkombination nicht auf R, G und B beschränkt. Es können auch mehr als drei Farben verwendet werden, z.B. sind zur Erzeugung hoher Farbwiedergaben Kombinationen aus R, G, B mit (phosphorkonvertierten) weißen (W) und auch gelben (Y) LEDs vorteilhaft. Vorteilhaft insbesondere zur Erzeugung eines warmweißen Farbtons können beispielsweise auch weniger als drei Farben, also eine oder mehrere rote oder gelbe LEDs und / oder phosphorkonvertierte LEDs, insbesondere in weiß (W) oder mintgrün (M) vorhanden sein. Bei LEDs mit unterschiedlichen Farben können diese auch so angesteuert werden, dass die LED-Gruppe in einem durchstimmbaren RGB-Farbbereich abstrahlt. Zur Erzeugung eines weißen Lichts aus einer Mischung von blauem Licht mit gelbem Licht können auch mit Leuchtstoff versehene LED-Chips verwendet werden, z. B. in Oberflächenmontagetechnik, z. B. in sog. Chip-Level-Konversionstechnik. Es können auch andere Methoden verwendet werden, wie eine rot/grün-Kombination mittels der Konversionstechnik. Es ist auch eine "klassische" Volumenkonversion möglich. Eine LED-Gruppe kann auch mehrere weiße Einzel-Chips aufweisen, wodurch sich eine einfache Skalierbarkeit des Lichtstroms erreichen lässt. Die Einzel-LEDs und / oder die LED-Gruppen können mit geeigneten Optiken zur Strahlführung ausgerüstet sein, z. B. Fresnel-Linsen, Kollimatoren, und so weiter. Statt oder zusätzlich zu anorganischen Leuchtdioden, z. B. auf Basis von InGaN oder AlInGaP, sind allgemein auch organische LEDs (OLEDs) einsetzbar.

Der Träger kann dadurch flexibel gestaltet werden, dass er aus einem flexiblen bzw. nachgiebigen Grundmaterial hergestellt ist. Der Träger kann dazu vorgesehen sein, einmal oder mehrmals gebogen zu werden. Ein mögliches Grundmaterial kann beispielsweise Polyester, FR4, PEN (Polyethylen-Naphtalat) und / oder PI (Polyimid) umfassen.

Der Träger kann zusätzlich oder alternativ zur Erreichung der Biegbarkeit bzw. Verformbarkeit strukturiert sein. Dazu kann der Träger beispielsweise mindestens eine Abdünnung wie eine Dehnungsfuge aufweisen, und zwar auf einer Oberseite und / oder einer Unterseite des Trägers.

Es kann eine Ausgestaltung sein, dass der Träger an einem Streifen, der mindestens unterhalb der Lichtquellen verläuft, nicht für eine Biegung vorgesehen ist und an mindestens einem Streifen, welcher bezüglich der Lichtquellen seitlich verläuft, für eine Biegung vorgesehen ist. Dadurch kann vermieden werden, dass eine Befestigung und / oder eine Kontaktierung der Lichtquellen durch die Biegung verloren geht und so zu einem Funktionsausfall führt.

Es kann auch eine Ausgestaltung sein, dass der Träger zumindest an dem mindestens einen seitlich verlaufenden Streifen mindestens eine Wärmeaufspreizungsfläche aufweist. Dadurch kann die Größe der Wärmeaufspreizungsfläche erhöht und folglich eine Kühlung der Wärmequellen des Leuchtmoduls verbessert werden. Die Wärmeaufspreizungsfläche kann durch ein gut wärmeleitendes Material gebildet werden, z. B. durch eine Kupferbeschichtung.

Es kann ferner eine Ausgestaltung sein, dass zumindest ein Teil der mindestens einen Wärmeaufspreizungsfläche durch mindestens eine Leiterbahn gebildet wird. Durch diese Doppelfunktionalität der Leiterbahn zur elektrischen und thermischen Leitung kann das Leuchtmodul preiswerter hergestellt werden, da das Material für separate Leiterbahnen eingespart werden kann. Eine Form, eine Zahl und ein Verlauf der Leiterbahnen ist nicht beschränkt und kann beispielsweise gerade oder gekrümmte, z. B. mäanderförmig verlaufende, Leiterbahnen und / oder sich verbreiternde und wieder verjüngende Leiterbahnen umfassen.

Es kann außerdem eine Ausgestaltung sein, dass der mindestens eine für eine Biegung vorgesehene Streifen mindestens eine Auflagefläche umfasst. Dadurch kann eine Wärmeableitung von dem Träger auf eine Unterlage, auf welcher der Träger aufliegt, stark verbessert werden.

Die Auflagefläche kann zur Befestigung auf einer Unterlage eine Haftschicht aufweisen, insbesondere aus einem thermisch leitenden Kleber.

Es kann noch eine weitere Ausgestaltung sein, dass das Leuchtmodul mindestens eine sich entlang einer Längsrichtung des Trägers erstreckende Dehnungsfuge aufweist. Dadurch kann eine Biegbarkeit des Trägers erreicht werden und / oder es kann eine gute Definition von vorbestimmten Biegekanten erreicht werden. Die mindestens eine Dehnungsfuge kann sich in einer Ausgestaltung an der Grenze zwischen dem unterhalb der Lichtquellen verlaufenden Streifen und einem seitlich verlaufenden Streifen befinden und so den seitlich verlaufenden Streifen und den unterhalb der Lichtquellen verlaufenden Streifen bezüglich einer Biegung entkoppeln. So werden eine Biegung des unterhalb der Lichtquellen verlaufenden Streifens und eine dadurch bedingte Ablösung der Lichtquellen oder der anderen elektronischen Bauteile oder Wärmequellen verhindert. Es kann noch eine Ausgestaltung sein, dass das Leuchtmodul mindestens einen Reflektor aufweist. Dadurch kann eine Strahlführung definiert ausgestaltet werden.

Es kann dann eine Weiterbildung sein, dass der Reflektor als eine reflektierende Fläche des Trägers oder als ein auf den Träger aufgesetztes, separat hergestelltes Reflektorelement vorliegt oder ausgestaltet ist. Die reflektierende Fläche kann beispielsweise durch ein Polieren der Wärmeaufspreizungsfläche(n) zu einer spiegelnden Fläche oder durch eine Aufbringung mindestens einer reflektierenden Schicht gebildet werden. Die reflektierende Fläche des Trägers kann beispielsweise in Form einer metallischen oder dielektrischen Spiegelschicht oder eines metallischen und/oder dielektrischen Spiegel-Schichtverbunds vorliegen.

Die Aufgabe kann auch gelöst werden durch eine Leuchte, welche eine gebogene Unterlage und mindestens ein solches Leuchtmodul aufweist, wobei das Leuchtmodul zumindest bereichsweise mit seinem in seiner Breite gebogenen Teil flächig an der Unterlage befestigt ist. In anderen Worten ist das Leuchtmodul mit einer zumindest über einen Teil seiner Breite gebogenen Auflagefläche mit der Unterlage verbunden. Dadurch kann das Leuchtmodul auch an einer stark in Breitenrichtung des Leuchtmoduls gebogenen Unterlage befestigt werden. Dies erleichtert eine einfache Befestigung ohne weitere Hilfsmittel, welche zudem beispielsweise stark haftend aufgeführt werden kann. Zudem wird so eine optisch vorteilhafte geometrisch konforme Anpassung des Leuchtmoduls an der Unterlage erreicht.

Die Unterlage ist in Form eines Rohrs ausgebildet und mindestens eine Leuchtmodul ist so längs in dem Rohr angeordnet dass das mindestens eine Leuchtmodul zumindest teilweise an einer gekrümmten Innenfläche des Rohrs angebracht ist. Dadurch kann das Leuchtmodul auf einfache Weise an dem Rohr befestigt werden und eine gute Wärmeübertragung auf das Rohr erreicht werden.

Das mindestens eine Leuchtmodul kann in ein vorgefertigtes Rohr eingesetzt werden oder auf einer offenen Unterlage aufgebracht und zusammen mit der Unterlage zu einem Rohr umgeformt werden.

Es kann noch eine Ausgestaltung sein, dass die Lichtquellen in mehreren Reihen auf der Unterlage angeordnet sind. Dadurch kann beispielsweise in einem Rohr der Öffnungswinkel des resultierenden Lichtstrahls vergrößert werden. Dies kann beispielsweise für eine Leuchtvorrichtung vorteilhaft sein, welche als eine Leuchtstoffröhren-Retrofit-Lampe ausgestaltet ist.

Es kann eine Weiterbildung sein, dass der mindestens eine Träger mehrere Reihen von Lichtquellen aufweist. Es kann noch eine Weiterbildung sein, dass mehrere Träger mit jeweils einer Reihe von Lichtquellen in Reihe zueinander angeordnet sind.

Der mindestens eine Träger liegt mit einer Unterseite auf der Unterlage, insbesondere Rohr. Dadurch weisen die Lichtquellen beispielsweise bei der Verwendung in einem Rohr in den Innenraum und folglich wird das von den Lichtquellen abgestrahlte Licht in das Rohr abgestrahlt. Dadurch kann der Vorteil erreicht werden, dass das Rohr als ein optisches Element (z. B. als eine Streuschicht) für die Lichtquellen verwendet werden kann. Zudem ist das mindestens eine Leuchtmodul durch das Rohr umfassend geschützt.

Das Rohr kann vollständig oder teilweise aus einem lichtdurchlässigen Material bestehen. Das Material kann in einer Weiterbildung transparent sein. Das Material kann in einer anderen Weiterbildung opak sein; so kann eine Homogenisierung der Lichtabstrahlung von dem Rohr nach außen verbessert werden.

In einer anderen Ausgestaltung kann die Leuchtvorrichtung bzw. ihre Mantelfläche mindestens ein Lichtdurchtrittsfenster aufweisen und ansonsten lichtundurchlässig sein. Der lichtundurchlässige Bereich kann als eine Blende dienen. Das Material des lichtundurchlässigen Bereichs kann ferner auf eine hohe Wärmeleitfähigkeit und / oder auf eine hohe Festigkeit hin optimiert sein.

Es kann eine Weiterbildung sein, dass das mindestens eine Lichtdurchtrittsfenster das Leuchtmodul, insbesondere den mindestens einen Träger, fixiert, z. B. auf seine Unterlage drückt. Dadurch kann eine besonders zuverlässige Befestigung des Leuchtmoduls an der Leuchtvorrichtung ohne separate Befestigungsmittel erreicht werden.

Es kann eine alternative Ausgestaltung sein, dass der mindestens eine Träger mit seiner Oberseite auf der Unterlage, insbesondere Rohr, aufliegt. Dadurch weisen die Lichtquellen beispielsweise bei der Verwendung in einem Rohr nach außen und nicht mehr nach innen in das Rohr. Um einen flächigen Sitz des Trägers und nicht der Lichtquellen auf der Unterlage zu erreichen, ragen die Lichtquellen in mindestens eine in dem Rohr eingebrachte Aussparung. Die mindestens eine Aussparung kann insbesondere eine Durchführung sein, wodurch eine direkte Kühlung der Lichtquellen vereinfacht wird.

In den folgenden Figuren wird die Erfindung anhand von Ausführungsbeispielen schematisch beschrieben. Dabei können zur Übersichtlichkeit gleiche oder gleichwirkende Elemente mit gleichen Bezugszeichen versehen sein.
- Fig. 1: zeigt in Vorderansicht eine Leuchtvorrichtung mit einem Leuchtmodul gemäß einer ersten Ausführungsform;
- Fig. 2: zeigt die Leuchtvorrichtung gemäß der ersten Ausführungsform ausschnittsweise in Schrägansicht;
- Fig. 3: zeigt das Leuchtmodul gemäß der Leuchtvorrichtung der ersten Ausführungsform in einer Ansicht von unten;
- Fig. 4: zeigt in Vorderansicht das Leuchtmodul gemäß der Leuchtvorrichtung der ersten Ausführungsform;
- Fig. 5: zeigt in Vorderansicht eine Leuchtvorrichtung gemäß einer zweiten Ausführungsform;
- Fig. 6: zeigt in Vorderansicht eine Leuchtvorrichtung gemäß einer dritten Ausführungsform;
- Fig. 7: zeigt in Vorderansicht eine Leuchtvorrichtung gemäß einer vierten Ausführungsform;
- Fig. 8: zeigt in Vorderansicht eine Leuchtvorrichtung gemäß einer fünften Ausführungsform;
- Fig. 9: zeigt in Schrägansicht eine Leuchtvorrichtung gemäß einer fünften Ausführungsform;
- Fig. 10: zeigt in Vorderansicht eine Leuchtvorrichtung gemäß einer sechsten Ausführungsform;
- Fig. 11: zeigt in Schrägansicht eine Leuchtvorrichtung die nicht Teil der Erfindung ist;
- Fig. 12: zeigt als Schnittdarstellung eine Leuchtvorrichtung die nicht Teil der Erfindung ist;
- Fig. 13: zeigt ein Leuchtmodul gemäß einer Leuchtvorrichtung die nicht Teil der Erfindung ist.

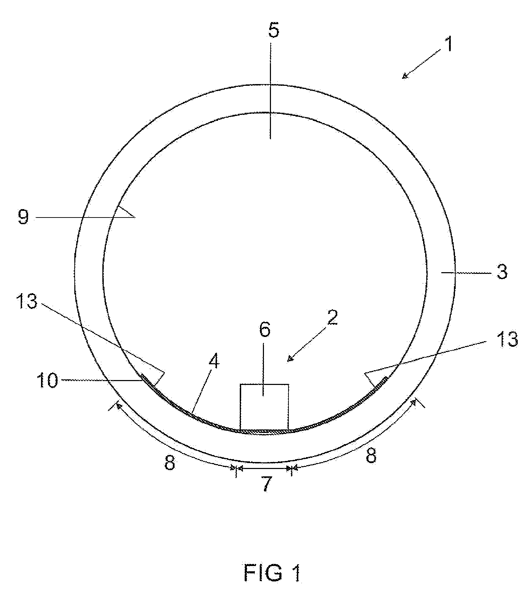

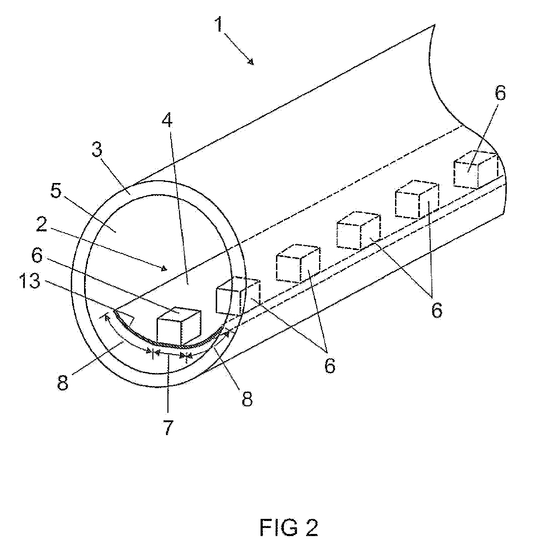

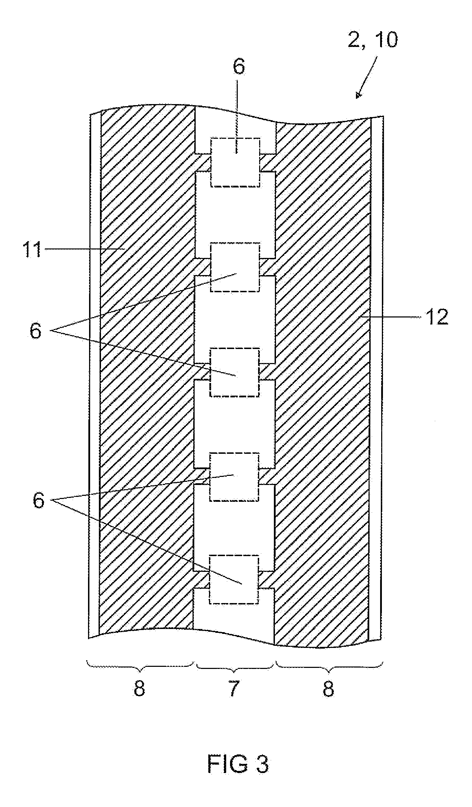

**Fig. 1** zeigt in Vorderansicht und **Fig. 2** zeigt in Schrägansicht eine Leuchtvorrichtung 1 gemäß einer ersten Ausführungsform. Die Leuchtvorrichtung 1 weist ein Leuchtmodul 2 auf, welches auf einer Unterlage in Form eines Rohrs 3 aufliegt. Das Leuchtmodul 2 umfasst einen flexiblen bandförmigen Träger 4 für mehrere Wärmequellen, nämlich Lichtquellen 6 und ggf. elektronische Bauelemente, in Form von nach oben in den Innenraum 5 des Rohrs 3 abstrahlenden Leuchtdioden ("Top-LEDs"). Der Träger 4 ist dergestalt über einen Teil seiner Breite gebogen, dass der Träger 4 sich an den zentralen Streifen 7, die unterhalb der Lichtquellen 6 und etwas seitlich darüber hinausstehend verlaufen, nicht biegt und an zwei seitlichen Streifen 8, welche bezüglich der Lichtquellen 6 seitlich verlaufen, gebogen ist. Dadurch liegt das Leuchtmodul 2 mit den seitlichen Streifen 8 des Trägers 4 flächig auf einer gekrümmten Innenseite 9 des Rohrs 3 auf und weist zwischen dem zentralen Streifen 7 und dem Rohr 3 eine Lücke auf. Die Befestigung kann durch ein Ankleben der seitlichen Streifen 8 auf der Innenseite 9 des Rohrs 3 erreicht werden. Die seitlichen Streifen 8 stellen somit die Auflageflächen des Trägers 4. An einer Unterseite 10 des jeweiligen seitlichen Streifens 8 befindet sich hier beispielhaft jeweils eine Wärmeaufspreizungsfläche, welche durch eine Leiterbahn aus Kupfer gebildet wird, wie genauer weiter unten in Fig. 3 beschrieben wird.

Dadurch, dass der Träger 4 in dem zentralen Streifen 7 nicht gebogen ist, wird eine möglicherweise durch eine Biegung verursachte Ablösung der Lichtquellen 6 oder ein Brechen von elektrischen Kontakten verhindert. Durch die flächige Auflage auf dem Rohr 3 kann eine gute Haftung und eine großflächige Wärmeübertragung von dem Leuchtmodul 2 auf das Rohr 3 erreicht werden.

Bei einem Betrieb des Leuchtmoduls 2 wird das von den Lichtquellen 6 emittierte Licht in den Innenraum 5 des Rohrs 3 abgestrahlt. In der gezeigten Ausführungsform besteht das Rohr 3 aus einem elektrisch isolierenden und milchig-weißen lichtdurchlässigen Kunststoff oder Glas, so dass das Licht im Wesentlichen aus einer bezüglich des Leuchtmoduls 2 oberen Hälfte des Rohrs 3 als im Wesentlichen diffuses Licht austritt und das Leuchtmodul 2 nicht oder nicht scharf sichtbar ist. Die Leuchtvorrichtung 1 kann beispielsweise als eine Leuchtstoffröhren-Retrofitlampe mit einer gerichteten Abstrahlcharakteristik verwendet werden.

Das Leuchtmodul 2 kann beispielsweise analog zu einem LED-Flex-Band der LINEARlight Flex-Reihe der Fa. Osram hergestellt werden, insbesondere als ein Quasi-Endlos-Band in einem Rolle-zu-Rolle-Verfahren.

**Fig. 3** zeigt das Leuchtmodul 2 in einem nicht-gebogenen Zustand von unten. Die Lichtquellen 6 sind an der hier gestrichelt angedeuteten Position an der Oberseite des Trägers 4 angeordnet und rein beispielhaft elektrisch parallel miteinander verbunden. Dazu sind die Lichtquellen 6 jeweils an zwei gemeinsame elektrische Leitungen 11, 12 aus Kupfer angeschlossen, zwischen welche ein elektrisches Potential angelegt werden kann. Allgemein kann eine Verschaltung der Lichtquellen 6 und ggf. der anderen Wärmequellen wie Treiberbausteine auch auf eine andere Weise erfolgen und beispielsweise auch nur eine oder mehr als zwei elektrische Leitungen erfordern. Die elektrischen Leitungen 11, 12 verlaufen im Wesentlichen an der Unterseite des Trägers 4 an dem jeweiligen seitlichen Streifen 8 und sind dort auf fast die volle Breite des jeweiligen seitlichen Streifens 8 aufgeweitet, um eine große wärmeleitfähige Auflagefläche auf dem Rohr oder einer anderen Unterlage bereitzustellen. Über diese Auflagefläche kann die von den Wärmequellen des Leuchtmoduls 2, einschließlich der Lichtquellen 6, erzeugte Wärme effektiv abgeleitet werden. In dem zentralen Streifen 7 verlaufen im Wesentlichen keine Leiterbahnen, was allgemein jedoch nicht zwingend ist.

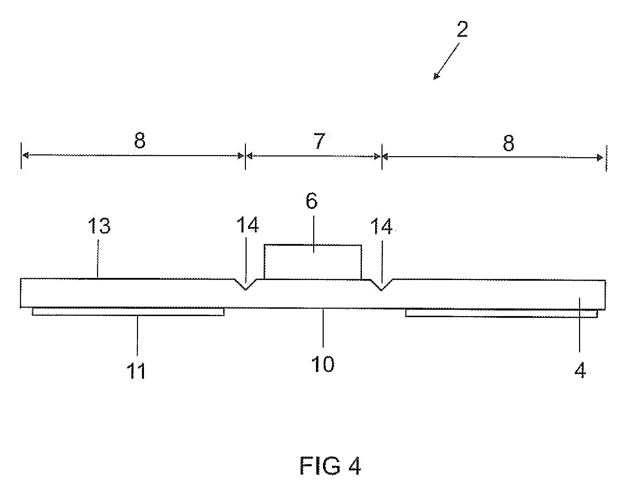

**Fig. 4** zeigt von vorne eine Detailansicht des Leuchtmoduls 2. Zur Vermeidung einer Biegung bzw. Krümmung des zentralen Streifens 7 weist eine Oberseite 13, welche auch die Lichtquellen 6 trägt, eine sich in Längsrichtung des Leuchtmoduls 2 (hier somit senkrecht zur Betrachtungsebene) ersteckende Dehnungsfuge 14 knapp seitlich neben der Lichtquelle 6 auf. Dadurch wird verhindert, dass bei einem Aufsetzen des Trägers 4 auf dem Rohr eine Biegung des seitlichen Streifens 8 nach oben auf den zentralen Streifen 7 übergeht. Vielmehr wird an der Dehnungsfuge 14 der seitliche Streifen 8 gegen den zentralen Streifen 7 angewinkelt. Durch eine Einbringung an derjenigen Seite (hier der Oberseite 13), zu der hin eine Biegung erfolgt, wird ein Verlauf der elektrischen Leitungen 11, 12 nicht behindert. Die Dehnungsfuge kann über die gesamte Länge der Leiterplatte laufen, oder aber auch unterbrochen sein, um z. B. die Realisierung von Leiterbahnen oder Wärmespreizflächen an der Oberfläche zu ermöglichen.

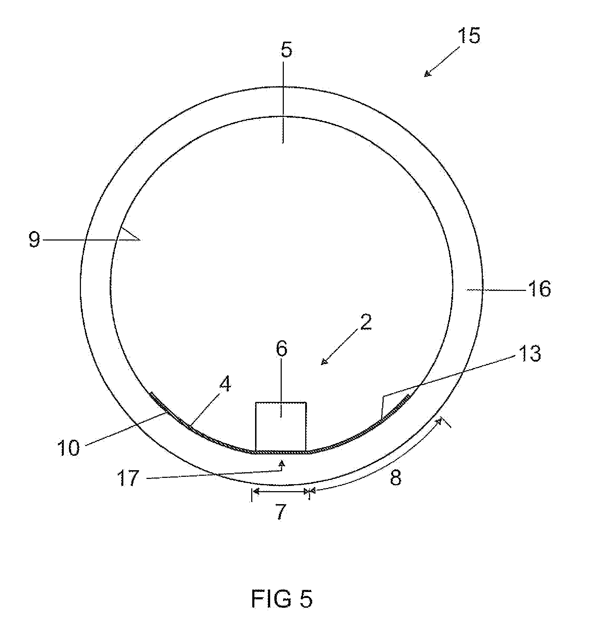

**Fig. 5** zeigt in Vorderansicht eine Leuchtvorrichtung 15 gemäß einer zweiten Ausführungsform. Diese Leuchtvorrichtung 15 unterscheidet sich von der Leuchtvorrichtung 1 dadurch, dass das Rohr 16 eine ebene Abflachung 17 aufweist, auf welche der zentrale Streifen 7 des Leuchtmoduls 2 passend flächig aufsetzbar ist. Dadurch kann eine mechanische und / oder thermische Bindung auch des zentralen Streifens 7 an das Rohr 16 erreicht werden.

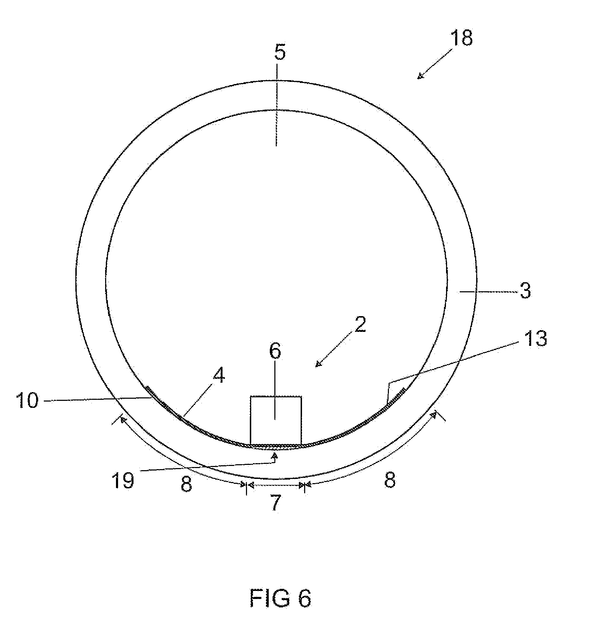

**Fig. 6** zeigt in Vorderansicht eine Leuchtvorrichtung 18 gemäß einer dritten Ausführungsform. Im Gegensatz zu der Leuchtvorrichtung 1 der ersten Ausführungsform ist der Spalt zwischen dem zentralen Streifen 7 und dem Rohr 3 nun mit einem zumindest thermisch leitfähigen Material 19 gefüllt, z. B. einem Metallstreifen oder einem Wärmeübergangsmaterial (TIM; "Thermal Interface Material"). So kann - ohne eine Anpassung des

Rohrs 3 - eine mechanische und / oder thermische Bindung des zentralen Streifens 7 an das Rohr 3 erreicht werden.

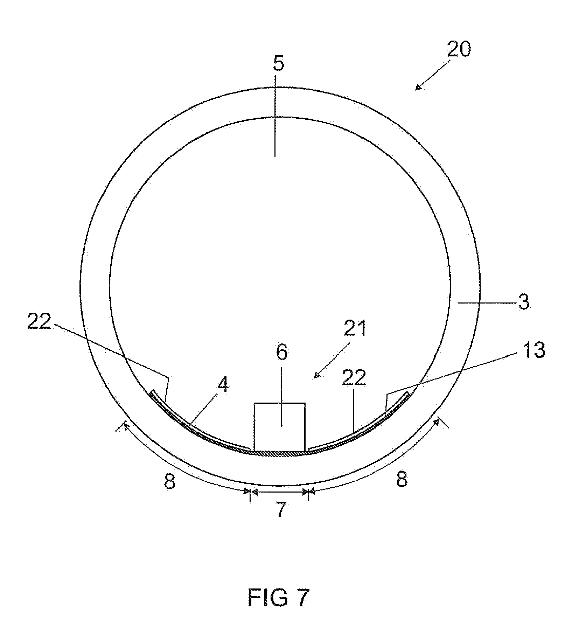

**Fig. 7** zeigt in Vorderansicht eine Leuchtvorrichtung 20 gemäß einer vierten Ausführungsform mit einem Leuchtmodul 21. Im Gegensatz zu den zuvor beschriebenen Ausführungsformen ist die nach oben gekrümmte Oberseite 13 der seitlichen Streifen 8 des Trägers 4, welcher auch mit den Lichtquellen 6 bestückt ist, mit einer Reflektorschicht 22 belegt, z. B. einer spiegelnden Aluminiumschicht oder Aluminiumfolie. Dadurch kann eine höhere Lichtausbeute und / oder eine verbesserte Strahlführung, z. B. Fokussierung, erreicht werden. Alternativ kann auf den Träger 4 ein separat hergestelltes Reflektorelement aufgesetzt werden. Das separat hergestellte Reflektorelement kann beispielsweise ein metallischer Reflektor oder ein mit einer spiegelnden Schicht, z. B. Metallisierung, ausgerüsteter Kunststoffreflektor sein.

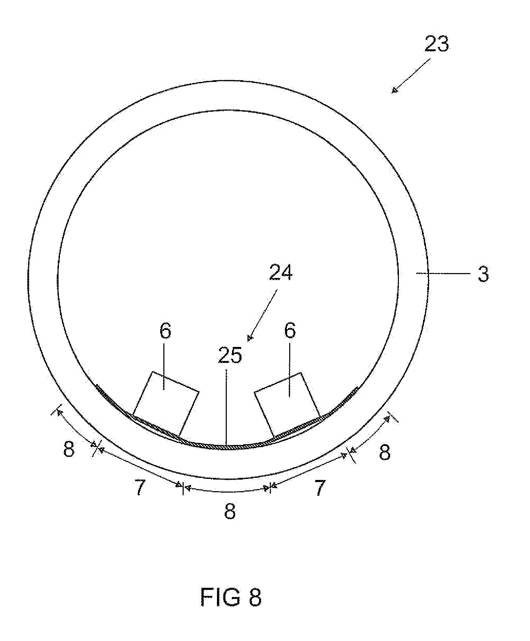

**Fig. 8** zeigt in Vorderansicht eine Leuchtvorrichtung 23 gemäß einer fünften Ausführungsform. Die Leuchtvorrichtung 23 weist ein Leuchtmodul 24 mit einem Träger 25 auf, welcher Lichtquellen 6 in zwei Längsreihen angeordnet umfasst. Dadurch entstehen zwei zentrale Streifen 7 unterhalb jeweils einer Reihe der Lichtquellen 6 und drei seitliche Streifen 8, wobei der mittlere seitliche Streifen 8 einen 'gemeinsamen' seitlichen Streifen 8 der beiden Reihen von Lichtquellen 6 darstellt. Die Leuchtvorrichtung 23 weist den Vorteil auf, dass sie eine höhere Lichtstärke erzeugen kann als die einreihigen Leuchtvorrichtungen und einen breiteren Abstrahlwinkel aufweist. Falls es im Vergleich zu einer einreihigen Ausführungsform nicht auf eine Erhöhung der Leuchtstärke sondern auf eine Verbreiterung des Austrittswinkels des Lichtstrahls ankommt, kann auch eine bezüglich der Längsrichtung zwischen den Reihen alternierende Anordnung der Lichtquellen 6 vorgesehen sein. Grundsätzlich ist auch ein Vorsehen von mehr als zwei Reihen von Lichtquellen möglich.

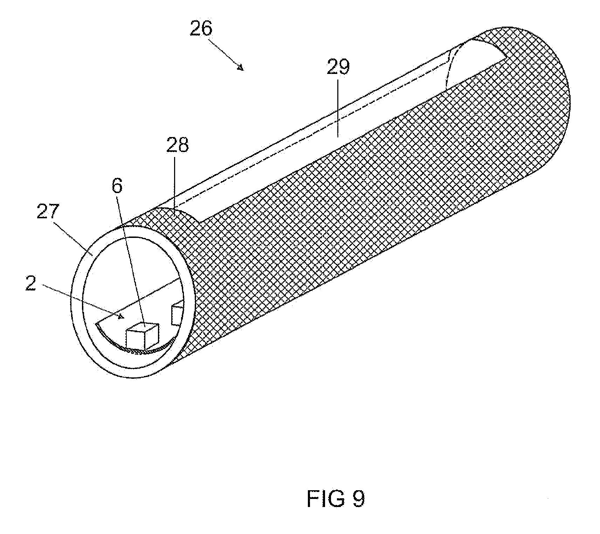

**Fig. 9** zeigt in Schrägansicht eine Leuchtvorrichtung 26 gemäß einer fünften Ausführungsform. Die Leuchtvorrichtung 26 weist ein Rohr 27 mit einem lichtundurchlässigen Grundkörper 28 und einem direkt oberhalb des Leuchtmoduls 2 an dem Grundkörper 28 befestigten lichtdurchlässigen transparenten oder opaken Lichtdurchtrittsfenster 29 auf. Dadurch kann der Grundkörper 28 die Funktion einer Blende übernehmen und einen aus der Leuchtvorrichtung 26 austretenden Lichtstrahl definiert begrenzen. Außerdem kann der Grundkörper 28 nun einfach aus einem preiswerten thermisch leitenden Material bestehen, z. B. einem Metall (Stahlblech, Aluminium usw.), und so als ein Kühlkörper dienen. Das Lichtdurchtrittsfenster 29 kann beispielsweise aus einem Kunststoff, einem Glas oder einer Glaskeramik bestehen.

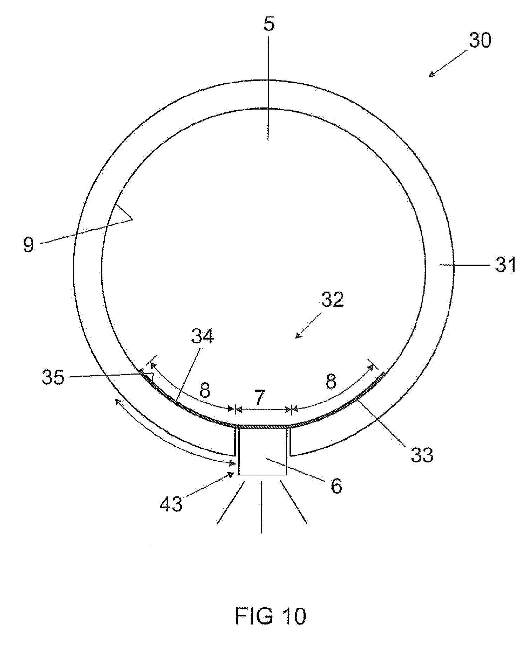

**Fig. 10** zeigt in Vorderansicht eine Leuchtvorrichtung 30 gemäß einer sechsten Ausführungsform. Diese Leuchtvorrichtung 30 weist ein Rohr 31 mit einer oder mehreren Durchführungen 43 zur Durchführung der Lichtquellen 6 auf. Dadurch ist es möglich, das Leuchtmodul 32 mit seiner Oberseite, insbesondere mit einer Oberseite 33 eines seitlichen Streifens 8 des Trägers 34, flächig und wärmeleitend auf der Innenseite 9 des Rohrs 31 zu befestigen. Dadurch strahlen die Lichtquellen 6 nicht mehr in den Innenraum 5 des Rohrs 31, sondern direkt nach außen ab. Dies hat den Vorteil, dass keine Absorption oder Dämpfung der Lichtstrahlung durch das Rohr 31 stattfindet.

In dieser Ausführungsform können die Wärmeaufspreizungsflächen, z. B. in Form von elektrischen Leiterbahnen, an der Oberseite 33 des Trägers 34 angeordnet sein und ggf. vorhandene Dehnungsfugen oder ähnliche Ausdünnungen z. B. an der Rückseite 35.

Die zuvor beschriebenen Leuchtmodule der ersten bis sechsten Ausführungsform weisen einen bandförmigen Träger dergestalt auf, dass seine Längserstreckung, welche der Ausrichtung der Lichtquellen entspricht, wesentlich größer ist als seine Quererstreckung (Erstreckung in Breitenrichtung), z. B. mehr als zweimal größer.

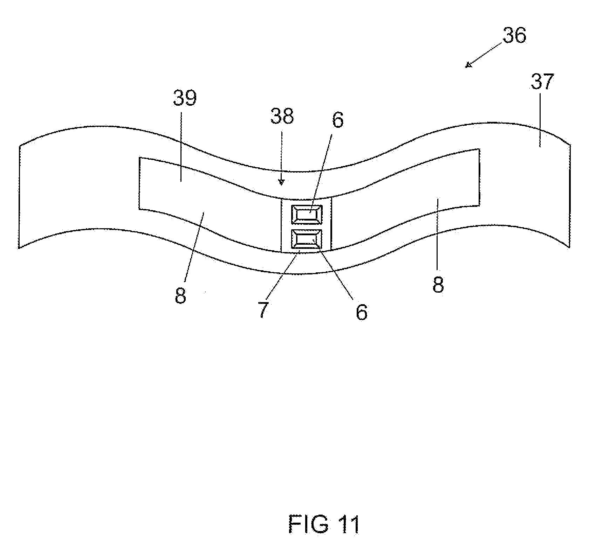

**Fig. 11** zeigt in Schrägansicht eine Leuchtvorrichtung 36 die nicht Teil der Erfindung ist. Die Unterlage 37, z. B. aus einem Metall, für das Leuchtmodul 38 ist nun nicht mehr rohrförmig, sondern wellenförmig geschwungen. Das Leuchtmodul 38 liegt in einem 'Wellental' auf der Unterlage 37 auf. Im Gegensatz zu den zuvor beschriebenen Leuchtmodulen der ersten bis sechsten Ausführungsform weist das Leuchtmodul 38 nun einen bandförmigen Träger 39 dergestalt auf, dass seine Längserstreckung, welche der Ausrichtung der lediglich zwei Lichtquellen 6 entspricht, geringer ist als seine Quererstreckung. Eine bandförmige Ausgestaltung bezieht sich somit hier auf eine zumindest abschnittsweise gerichtete Erstreckung der Lichtquellen und / oder des Trägers. Folglich ist die Breite der die Wärmespreizflächen beinhaltenden seitlichen Streifen 8 hier weitaus größer als die Breite des zentralen Streifens 7.

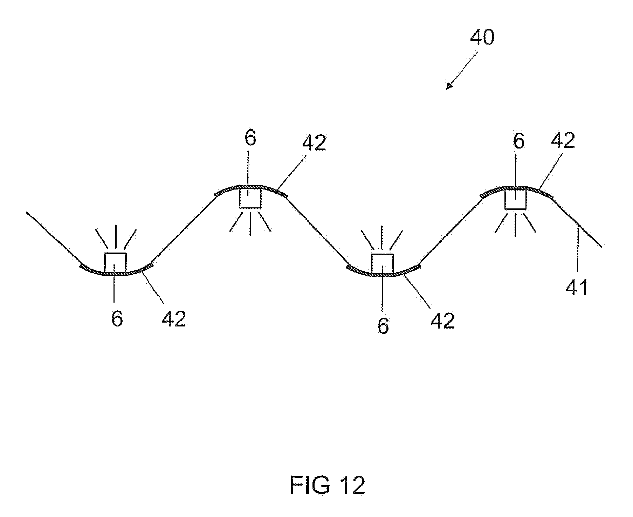

**Fig. 12** zeigt als Schnittdarstellung eine Leuchtvorrichtung 40 die nicht Teil der Erfindung ist. Die Leuchtvorrichtung 40 weist ebenfalls eine wellenförmige Unterlage 41 auf, bei der auf den Wellentälern und Wellenbergen jeweils ein einreihiges Leuchtmodul 42 entlangläuft. Die Leuchtmodule 42 können wie in der ersten bis fünften Ausführungsform gezeigt mit ihrer Unterseite auf der Unterlage 41 befestigt sein oder wie in der sechsten Ausführungsform mit ihrer Oberseite, wobei die Unterlage 41 dann mindestens eine Durchführung für die Lichtquellen 6 aufweist. Die wellenförmige Unterlage 41 ist nur ein Beispiel für eine beliebig geformte Unterlage, auf welche ein über seine Breite zumindest teilweise biegsames Leuchtmodul aufbringbar ist.

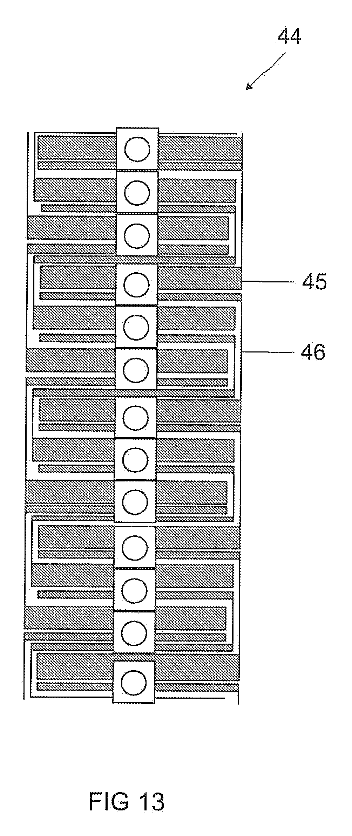

**Fig. 13** zeigt ein Leuchtmodul 44 von unten, bei dem nun die zwei Leiterbahnen 45, 46 jeweils abschnittsweise mäanderförmig verlaufen und zudem eine wechselnde Breite einnehmen. So wird die durch die Leiterbahnen 45, 46 erzeugte Wärmeaufspreizungsfläche sehr groß gehalten.

Selbstverständlich ist die vorliegende Erfindung nicht auf die gezeigten Ausführungsbeispiele beschränkt.

So kann die Form der elektrischen Leitungen frei gewählt werden und beispielsweise mäanderförmig zwischen zwei Lichtquellen ausgestaltet sein. Bei mehr als einer elektrischen Leitung pro seitlichem Streifen können diese gleich oder unterschiedlich ausgestaltet sein, und zwar bezüglich ihres Verlaufs und / oder ihrer Größe (Leiterbahnbreite usw.).

Der mindestens eine Dehnungsstreifen kann auch zur Herstellung einer Biegsamkeit bzw. Flexibilität eines ansonsten nicht für eine Biegung vorgesehenen Trägers vorgesehen sein; beispielsweise durch eine Einbringung mehrerer Dehnungsfugen oder anderer lokaler Abdünnungen.

Außerdem kann es eine nicht gezeigte Weiterbildung sein, dass mehr als ein Lichtdurchtrittsfenster an einem Grundkörper vorhanden ist.

Es kann auch eine nicht gezeigte Weiterbildung sein, dass das mindestens eine Lichtdurchtrittsfenster gleichzeitig den mindestens einen Träger fixiert. Dazu kann das Lichtdurchtrittsfenster geeignete in den Innenraum des Rohrs ragende Vorsprünge aufweisen, z. B. Stäbe. Das Lichtaustrittsfenster kann auch als ein optisches Element ausgebildet sein, z. B. als eine Linse oder als ein Kollimator.

Allgemein können die Merkmale der einzelnen Ausführungsformen kombiniert werden, z. B. ist eine Ausführungsform mit mindestens einem Reflektor und einer mindestens zweireihigen Anordnung von Lichtquellen möglich.

### Bezugszeichenliste

- 1: Leuchtvorrichtung
- 2: Leuchtmodul
- 3: Rohr
- 4: Träger
- 5: Innenraum
- 6: Lichtquelle
- 7: zentraler Streifen
- 8: seitlicher Streifen
- 9: Innenseite des Rohrs
- 10: Unterseite eines seitlichen Streifens
- 11: elektrische Leitung
- 12: elektrische Leitung
- 13: Oberseite eines seitlichen Streifens
- 14: Dehnungsfuge
- 15: Leuchtvorrichtung
- 16: Rohr
- 17: Abflachung
- 18: Leuchtvorrichtung
- 19: thermisch leitfähiges Material
- 20: Leuchtvorrichtung
- 21: Leuchtmodul
- 22: Reflektorschicht
- 23: Leuchtvorrichtung
- 24: Leuchtmodul
- 25: Träger
- 26: Leuchtvorrichtung
- 27: Rohr
- 28: Grundkörper
- 29: Lichtdurchtrittsfenster
- 30: Leuchtvorrichtung
- 31: Rohr
- 32: Leuchtmodul
- 33: Oberseite
- 34: Träger
- 35: Unterseite
- 36: Leuchtvorrichtung
- 37: Unterlage
- 38: Leuchtmodul
- 39: Träger
- 40: Leuchtvorrichtung
- 41: Unterlage
- 42: Leuchtmodul
- 43: Durchführung
- 44: Leuchtmodul
- 45: Leiterbahn
- 46: Leiterbahn

## Patentansprüche

1. Leuchtvorrichtung (1;20;23;26;30;36;40), aufweisend eine gebogene Unterlage (3;16;27;31;41) und mindestens ein Leuchtmodul (2;21;24;32;38;42;44), aufweisend mindestens einen flexiblen, insbesondere bandförmigen, Träger (4;25;34;39) für mehrere Wärmequellen, einschließlich Lichtquellen (6), wobei der Träger (4;25;34;39) dazu vorgesehen ist, über zumindest einen Teil seiner Breite gebogen zu werden, wobei das Leuchtmodul (2; 21; 24; 32; 38; 42; 44) zumindest bereichsweise mit seinem in seiner Breite gebogenen Teil (8) flächig an der Unterlage (3;16;27;31;41) befestigt ist, **dadurch gekennzeichnet, dass** , die Unterlage in Form eines Rohrs (3;16;27;31) ausgebildet ist und das mindestens eine Leuchtmodul (2;21;24;32;44) so längs in dem Rohr (3;16;27;31) angeordnet ist, dass das mindestens eine Leuchtmodul (2;21;24;32;44) zumindest teilweise an einer gekrümmten Innenseite (9) des Rohrs (3;16;27;31) angebracht ist.

2. Leuchtvorrichtung (1;20;23;26;30;36;40) nach Anspruch 1, aufweisend mindestens ein Leuchtmodul (2;21;24;32;38;42;44), bei dem der Träger (4;25;34;39) an einem Streifen (7), der mindestens unterhalb der Lichtquellen (6) verläuft, nicht für eine Biegung vorgesehen ist und an mindestens einem Streifen (8), welcher bezüglich der Lichtquellen (6) seitlich verläuft, für eine Biegung vorgesehen ist.

3. Leuchtvorrichtung (1;20;23;26;30;36;40) nach Anspruch 2, aufweisend mindestens ein Leuchtmodul (2;21;24;32;38;42;44) nach Anspruch 2, bei dem der Träger (4;25;34;39) zumindest an dem mindestens einen bezüglich der Lichtquellen (6) seitlich verlaufenden Streifen (8) mindestens eine Wärmeaufspreizungsfläche (11,12; 45,46) aufweist.

4. Leuchtvorrichtung (1;20;23;26;30;36;40) nach Anspruch 3, aufweisend mindestens ein Leuchtmodul (2;21;24;32;38;42;44) nach Anspruch 3, bei dem zumindest ein Teil der mindestens einen Wärmeaufspreizungsfläche (11,12; 45,46) durch mindestens eine Leiterbahn (11,12; 45,46) gebildet wird.

5. Leuchtvorrichtung (1;20;23;26;30;36;40) nach einem der vorhergehenden Ansprüche, aufweisend mindestens ein Leuchtmodul (2;21;24;32;38;42;44) nach einem der vorhergehenden Ansprüche, bei dem der mindestens eine für eine Biegung vorgesehene Streifen (8) mindestens eine Auflagefläche umfasst.

6. Leuchtvorrichtung (1;20;23;26;30;36;40) nach einem der vorhergehenden Ansprüche, aufweisend mindestens ein Leuchtmodul (2)nach einem der vorhergehenden Ansprüche, aufweisend mindestens eine sich entlang einer Längsrichtung des Trägers (4) erstreckende Dehnungsfuge (14).

7. Leuchtvorrichtung (1;20;23;26;30;36;40) nach einem der vorhergehenden Ansprüche, aufweisend mindestens ein Leuchtmodul (21) nach einem der vorhergehenden Ansprüche, aufweisend mindestens einen Reflektor (22).

8. Leuchtvorrichtung (1;20;23;26;30;36;40) nach Anspruch 7, aufweisend mindestens ein Leuchtmodul (21) nach Anspruch 7, bei dem der Reflektor als ein separat hergestelltes Bauteil vorliegt oder der Reflektor (22) in Form einer Spiegelschicht auf dem Träger (4) aufgebracht ist.

9. Leuchtvorrichtung (23) nach einem der Ansprüche 1 bis 8, bei der die Lichtquellen (6) in mehreren Reihen angeordnet sind.

10. Leuchtvorrichtung (1;20;23;26) nach einem der Ansprüche 1 bis 9, bei welcher der mindestens eine Träger (4;25) mit einer Unterseite (10) auf dem Rohr aufliegt.

11. Leuchtvorrichtung (26) nach Anspruch 10, aufweisend mindestens ein Lichtdurchtrittsfenster (29).

12. Leuchtvorrichtung (26) nach Anspruch 11, bei der das mindestens eine Lichtdurchtrittsfenster (29) den mindestens einen Träger (4) fixiert.

13. Leuchtvorrichtung (30) nach einem der Ansprüche 1 bis 12, bei welcher der mindestens eine Träger (34) mit seiner Oberseite (33) auf dem Rohr (31) aufliegt und die Lichtquellen (6) in mindestens eine in dem Rohr (31) eingebrachte Durchführung (43) ragen.

## Claims

1. Lighting device (1; 20; 23; 26; 30; 36; 40), having a curved base (3; 16; 27; 31; 41) and at least one lighting module (2; 21; 24; 32; 38; 42; 44), having at least one flexible, in particular strip-like carrier (4; 25; 34; 39) for a plurality of heat sources, including light sources (6), the carrier (4; 25; 34; 39) being provided to be bent over at least part of its width, the lighting module (2; 21; 24; 32; 38; 42; 44) being fixed, at least in some areas, flatly to the base (3; 16; 27; 31; 41) by its part (8) bent in its width, **characterized in that** the base is constructed in the form of a tube (3; 16; 27; 31) and the at least one lighting module (2; 21; 24; 32; 44) is arranged longitudinally in the tube (3; 16; 27; 31) such that the at least one lighting module (2; 21; 24; 32; 44) is at least partly attached to a curved inner side (9) of the tube (3; 16; 27; 31).

2. Lighting device (1; 20; 23; 26; 30; 36; 40) according to Claim 1 having at least one lighting module (2; 21; 24; 32; 38; 42; 44), in which the carrier (4; 25; 34; 39) is not provided for a bend on a strip (7) which extends at least underneath the light sources (6), and is provided for a bend on at least one strip (8) which extends laterally with respect to the light sources (6).

3. Lighting device (1; 20; 23; 26; 30; 36; 40) according to Claim 2 having at least one lighting module (2; 21; 24; 32; 38; 42; 44) according to Claim 2, in which the carrier (4; 25; 34; 39) has at least one heat spreading surface (11, 12; 45, 46), at least on the at least one strip (8) extending laterally with respect to the light sources (6).

4. Lighting device (1; 20; 23; 26; 30; 36; 40) according to Claim 3 having at least one lighting module (2; 21; 24; 32; 38; 42; 44) according to Claim 3, in which at least part of the at least one heat spreading surface (11, 12; 45, 46) is formed by at least one conductor track (11, 12; 45, 46).

5. Lighting device (1; 20; 23; 26; 30; 36; 40) according to one of the preceding claims having at least one lighting module (2; 21; 24; 32; 38; 42; 44) according to one of the preceding claims, in which the at least one strip (8) provided for a bend comprises at least one supporting surface.

6. Lighting device (1; 20; 23; 26; 30; 36; 40) according to one of the preceding claims having at least one lighting module (2) according to one of the preceding claims, having at least one expansion joint (14) extending along a longitudinal direction of the carrier (4).

7. Lighting device (1; 20; 23; 26; 30; 36; 40) according to one of the preceding claims having at least one lighting module (21) according to one of the preceding claims, having at least one reflector (22).

8. Lighting device (1; 20; 23; 26; 30; 36; 40) according to Claim 7 having at least one lighting module (21) according to Claim 7, in which the reflector is present as a separately produced component or the reflector (22) is applied to a carrier (4) in the form of a reflective layer.

9. Lighting device (23) according to one of Claims 1 to 8, in which the light sources (6) are arranged in a plurality of rows.

10. Lighting device (1; 20; 23; 26) according to one of Claims 1 to 9, in which the at least one carrier (4; 25) rests with an underside (10) on the tube.

11. Lighting device (26) according to Claim 10, having at least one light transmission window (29).

12. Lighting device (26) according to Claim 11, in which the at least one light transmission window (29) fixes the at least one carrier (4).

13. Lighting device (30) according to one of Claims 1 to 12, in which the at least one carrier (34) rests with its upper side (33) on the tube (31), and the light sources (6) project into at least one lead-through (43) introduced into the tube (31).

## Revendications

1. Dispositif d'éclairage (1 ; 20 ; 23 ; 26 ; 30 ; 36 ; 40), comportant une base courbée (3 ; 16 ; 27 ; 31 ; 41) et au moins un module d'éclairage (2 ; 21 ; 24 ; 32 ; 38 ; 42 ; 44) comportant au moins un support (4 ; 25 ; 34 ; 39) flexible, en particulier en forme de bande, pour plusieurs sources de chaleur, y compris des sources de lumière (6), le support (4 ; 25 ; 34 ; 39) étant prévu pour être courbé sur au moins une partie de sa largeur, le module d'éclairage (2 ; 21 ; 24 ; 32 ; 38 ; 42 ; 44) étant fixé au moins en partie, par sa partie (8) courbée sur sa largeur, de manière plane à la base (3 ; 16 ; 27 ; 31 ; 41), **caractérisé en ce que** la base est réalisée en forme de tube (3 ; 16 ; 27 ; 31) et **en ce que** l'au moins un module d'éclairage (2 ; 21 ; 24 ; 32 ; 44) est agencé longitudinalement dans le tube (3 ; 16 ; 27 ; 31) de telle sorte que l'au moins un module d'éclairage (2 ; 21 ; 24 ; 32 ; 44) est monté au moins en partie sur une face intérieure courbée (9) du tube (3 ; 16 ; 27 ; 31).

2. Dispositif d'éclairage (1 ; 20 ; 23 ; 26 ; 30 ; 36 ; 40) selon la revendication 1, comportant au moins un module d'éclairage (2 ; 21 ; 24 ; 32 ; 38 ; 42 ; 44) dans lequel le support (4 ; 25 ; 34 ; 39) est, au niveau d'une bande (7) passant au moins en dessous des sources de lumière (6), non prévu pour être courbé et, au niveau d'au moins une bande (8) latérale par rapport aux sources de lumière (6), prévu pour être courbé.

3. Dispositif d'éclairage (1 ; 20 ; 23 ; 26 ; 30 ; 36 ; 40) selon la revendication 2, comportant au moins un module d'éclairage (2 ; 21 ; 24 ; 32 ; 38 ; 42 ; 44) selon la revendication 2 et dans lequel le support (4 ; 25 ; 34 ; 39) comporte au moins une face d'écartement thermique (11, 12 ; 45, 46) au moins au niveau de l'au moins une bande (8) latérale par rapport aux sources de lumière (6).

4. Dispositif d'éclairage (1 ; 20 ; 23 ; 26 ; 30 ; 36 ; 40) selon la revendication 3, comportant au moins un module d'éclairage (2 ; 21 ; 24 ; 32 ; 38 ; 42 ; 44) selon la revendication 3 et dans lequel au moins une partie de l'au moins une face d'écartement thermique (11, 12 ; 45, 46) est constituée par au moins une piste conductrice (11, 12 ; 45, 46).

5. Dispositif d'éclairage (1 ; 20 ; 23 ; 26 ; 30 ; 36 ; 40) selon l'une des revendications précédentes, comportant au moins un module d'éclairage (2 ; 21 ; 24 ; 32 ; 38 ; 42 ; 44) selon l'une des revendications précédentes et dans lequel l'au moins une bande (8) prévue pour être courbée comprend au moins une surface d'appui.

6. Dispositif d'éclairage (1 ; 20 ; 23 ; 26 ; 30 ; 36 ; 40) selon l'une des revendications précédentes, comportant au moins un module d'éclairage (2) selon l'une des revendications précédentes et comportant au moins un joint de dilatation (14) qui s'étend le long d'une direction longitudinale du support (4).

7. Dispositif d'éclairage (1 ; 20 ; 23 ; 26 ; 30 ; 36 ; 40) selon l'une des revendications précédentes, comportant au moins un module d'éclairage (21) selon l'une des revendications précédentes et comportant au moins un réflecteur (22).

8. Dispositif d'éclairage (1 ; 20 ; 23 ; 26 ; 30 ; 36 ; 40) selon la revendication 7, comportant au moins un module d'éclairage (21) selon la revendication 7 et dans lequel le réflecteur se présente sous la forme d'un composant réalisé séparément ou le réflecteur (22) est monté sur le support (4) sous la forme d'une couche miroir.

9. Dispositif d'éclairage (23) selon l'une des revendications 1 à 8, dans lequel les sources de lumière (6) sont agencées en plusieurs rangées.

10. Dispositif d'éclairage (1 ; 20 ; 23 ; 26) selon l'une des revendications 1 à 9, dans lequel l'au moins un support (4 ; 25) prend appui sur le tube en une face inférieure (10).

11. Dispositif d'éclairage (26) selon la revendication 10, comportant au moins une fenêtre pour le passage de la lumière (29).

12. Dispositif d'éclairage (26) selon la revendication 11, dans lequel l'au moins une fenêtre pour le passage de la lumière (29) fixe l'au moins un support (4).

13. Dispositif d'éclairage (30) selon l'une des revendications 1 à 12, dans lequel l'au moins un support (34) prend appui sur le tube (31) en sa face supérieure (33) et les sources de lumière (6) font saillie dans au moins un passage (43) ménagé dans le tube (31).
